(19) Europäisches Patentamt
European Patent Office
Office européen des brevets

(11) **EP 4 109 062 A1**

(12) **EUROPEAN PATENT APPLICATION**
published in accordance with Art. 153(4) EPC

(43) Date of publication:
**28.12.2022 Bulletin 2022/52**

(21) Application number: **21756947.4**

(22) Date of filing: **17.02.2021**

(51) International Patent Classification (IPC):
**G01K 1/14** (2021.01)      **G01K 7/22** (2006.01)
**G01K 17/06** (2006.01)      **H01L 37/00** (2006.01)

(52) Cooperative Patent Classification (CPC):
**G01K 1/14; G01K 7/22; G01K 17/06; H01L 37/00**

(86) International application number:
**PCT/JP2021/005893**

(87) International publication number:
**WO 2021/166950 (26.08.2021 Gazette 2021/34)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **21.02.2020 JP 2020027859
25.11.2020 JP 2020194862**

(71) Applicant: **Mitsubishi Materials Corporation
Tokyo 100-8117 (JP)**

(72) Inventors:
• **FUJITA Toshiaki
Naka-shi Ibaraki 311-0102 (JP)**
• **ARAI Koya
Naka-shi Ibaraki 311-0102 (JP)**

(74) Representative: **Hoffmann Eitle
Patent- und Rechtsanwälte PartmbB
Arabellastraße 30
81925 München (DE)**

(54) **HEAT FLOW SWITCHING ELEMENT**

(57) Provided is a heat flow switching element that has a larger change in thermal conductivity, has excellent thermal responsiveness, and is capable of directly detecting a temperature change. The heat flow switching element according to the present invention includes: a heat flow control element part 10 including an N-type semiconductor layer 3, an insulator layer 4 laminated on the N-type semiconductor layer, and a P-type semiconductor layer 5 laminated on the insulator layer; and thermosensitive element parts 11A and 11B joined to the heat flow control element part. In addition, the thermosensitive element parts include: a thin-film thermistor portion made of a thermistor material; and a pair of counter electrodes formed facing each other on an upper side and/or a lower side of the thin-film thermistor portion, and the thin-film thermistor portion is laminated on an upper side and/or a lower side of the heat flow control element part.

[FIG. 1]

**Description**

Technical Field

The present invention relates to a heat flow switching element capable of actively controlling heat conduction with a bias voltage and directly detecting a temperature change.

Background Art

As an example of a conventional thermal switch that changes thermal conductivity, Patent Literature 1 describes a thermal diode in which two thermal conductors having different thermal expansion coefficients are lightly in contact with each other, and the flow of heat varies depending on the direction of the temperature gradient. Patent Literature 2 also describes a heat dissipation device that is a thermal switch in which physical thermal contact due to thermal expansion is used.

Patent Literature 3 describes a thermal conductivity variable device in which thermal conductivity is changed by a reversible oxidation-reduction reaction that occurs by applying a voltage to a compound.

Furthermore, Non Patent Literature 1 proposes a heat flow switching element that changes thermal conductivity by sandwiching a polyimide tape between two sheets of $Ag_2S_{0.6}Se_{0.4}$ and applying an electric field.

Citation List

Patent Literature

    Patent Literature 1: JP 2781892 B
    Patent Literature 2: JP 5402346 B
    Patent Literature 3: JP 2016-216688 A

Non Patent Literature

Non Patent Literature 1: Takuya Matsunaga and four others, "Preparation of Heat Flow Switching Element Operated with Bias Voltage", 15th Meeting of the Thermoelectrics Society of Japan, September 13, 2018

Summary of Invention

Technical Problem

The conventional techniques described above still have the following problems.

That is, in the techniques described in Patent Literatures 1 and 2, because physical thermal contact due to thermal expansion is used, reproducibility cannot be obtained, size design is particularly difficult owing to minute change, and plastic deformation due to mechanical contact pressure cannot be avoided. These techniques are also problematic in that the influence of convective heat transfer between materials is too large.

In addition, the technique described in Patent Literature 3, in which a chemical reaction, namely an oxidation-reduction reaction, is used, is disadvantageous in that thermal responsiveness is poor and thermal conduction is not stable.

On the other hand, in the technique described in Non Patent Literature 1, a voltage is applied to generate electric charges capable of thermal conduction at the material interface, and heat can be carried by the electric charges. Therefore, it is possible to immediately transition to a state in which thermal conduction has changed, and to obtain a relatively good thermal responsiveness. However, because the amount of electric charge generated is small, there is a demand for a heat flow switching element that generates an increased amount of electric charge and has a larger change in thermal conductivity.

Furthermore, there is a demand for a heat flow switching element capable of directly detecting how a change in thermal conductivity has caused a change in temperature. That is, there is a demand for a heat flow switching element having a temperature sensing function.

The present invention has been made in view of the above-described problems, and an object thereof is to provide a heat flow switching element that has a larger change in thermal conductivity, has excellent thermal responsiveness, and is capable of directly detecting a temperature change.

Solution to Problem

In order to solve the above problems, the present invention adopts the following configurations. That is, a heat flow switching element according to a first invention includes: a heat flow control element part including an N-type semiconductor layer, an insulator layer laminated on the N-type semiconductor layer, and a P-type semiconductor layer laminated on the insulator layer; and a thermosensitive element part joined to the heat flow control element part.

This heat flow switching element includes: the heat flow control element part including the N-type semiconductor layer, the insulator layer laminated on the N-type semiconductor layer, and the P-type semiconductor layer laminated on the insulator layer; and the thermosensitive element part joined to the heat flow control element part. Therefore, a voltage applied to the P-type semiconductor layer and the N-type semiconductor layer induces electric charges mainly at the interfaces between the P-type semiconductor layer and the insulator layer and between the N-type semiconductor layer and the insulator layer, and the thermal conductivity changes as the electric charges carry heat. In particular, because electric charges induced by the external voltage are generated both at the interface between the N-type semiconductor layer and the insulator layer and in the vicinity thereof and at the interface between the P-type semiconductor layer and the insulator layer and in the vicinity thereof, the amount of generated electric charge is so large that a large change in thermal conductivity and a high thermal responsiveness can be obtained. In addition, because of the mechanism that physically changes the thermal conductivity without using a chemical reaction mechanism, it is possible to immediately transition to a state in which thermal conduction has changed, and to obtain good thermal responsiveness.

In addition, because the amount of electric charge induced at the interfaces changes depending on the magnitude of the external voltage, it is possible to adjust the thermal conductivity by adjusting the external voltage, and thus to actively control the heat flow through the present element.

Note that the insulator layer is an insulator in which no current is generated due to voltage application; therefore, no Joule heat is generated. Thus, it is possible to actively control the heat flow without self-heating.

Furthermore, this heat flow switching element has a composite structure including the thermosensitive element part joined to the heat flow control element part. Therefore, the temperature change associated with a change in thermal conductivity by the heat flow control element part can be directly detected by the thermosensitive element part. That is, while the temperature is directly monitored by the thermosensitive element part, the heat flow can be adjusted with high responsiveness by the heat flow control element part of the voltage application type capable of high-speed thermal response.

A heat flow switching element according to a second invention is based on the first invention, wherein the thermosensitive element part includes: a thin-film thermistor portion made of a thermistor material; and a pair of counter electrodes formed facing each other on an upper side and/or a lower side of the thin-film thermistor portion, and the thin-film thermistor portion is laminated on an upper side and/or a lower side of the heat flow control element part.

That is, in this heat flow switching element, because the thin-film thermistor portion is laminated on the upper side and/or the lower side of the heat flow control element part, the thin-film thermistor portion is in surface contact with the heat flow control element part, which reduces the thermal resistance, enables accurate temperature detection, and contributes to reducing the thickness.

A heat flow switching element according to a third invention is based on the first or second invention, wherein the thermosensitive element part is provided on each of a high temperature side and a low temperature side of the heat flow control element part.

That is, in this heat flow switching element, because the thermosensitive element part is provided on each of the high temperature side and the low temperature side of the heat flow control element part, it is possible to detect the temperatures on both the high temperature side and the low temperature side of the heat flow control element part, and to more accurately detect the state of heat conduction that changes from moment to moment according to the heat flow direction. In addition, because the heat flow can be adjusted by the external voltage in the heat flow control element part according to the temperatures detected on both the high temperature side and the low temperature side, even when the temperature of an object in thermal contact with the heat flow switching element changes with time, heat flow switching with a very high thermal responsiveness can be performed according to the current state of heat conduction.

A heat flow switching element according to a fourth invention is based on any of the first to third inventions, wherein in the heat flow control element part, a plurality of the N-type semiconductor layers and a plurality of the P-type semiconductor layers are alternately laminated with the insulator layer interposed.

That is, in this heat flow switching element, because the plurality of N-type semiconductor layers and the plurality of P-type semiconductor layers are alternately laminated with the insulator layers interposed therebetween, a plurality of interfaces are formed between the N-type semiconductor layers and the insulator layers and between the P-type semiconductor layers and the insulator layers, which induces a large number of electric charges that can cause a significant change in thermal conductivity.

A heat flow switching element according to a fifth invention is based on any of the first to fourth inventions, and includes: an upper high thermal conductive part provided at an uppermost portion of the heat flow control element part;

a lower high thermal conductive part provided at a lowermost portion of the heat flow control element part; and an outer-peripheral heat insulating part provided covering an outer peripheral edge of the N-type semiconductor layer, the insulator layer, and the P-type semiconductor layer, wherein the upper high thermal conductive part and the lower high thermal conductive part are made of a material having a higher thermal conductivity than the outer-peripheral heat insulating part, and the thermosensitive element part is joined to the upper high thermal conductive part and/or the lower high thermal conductive part.

That is, in this heat flow switching element, because the upper high thermal conductive part and the lower high thermal conductive part are made of a material having a higher thermal conductivity than the outer-peripheral heat insulating part, it is possible to suppress the heat flow in the in-plane direction and to obtain a thermal switching property in the lamination direction. In particular, in a case where an N-side electrode and a P-side electrode are located on the outer periphery of the corresponding layers, the inflow of heat to these electrodes can be minimized by the outer-peripheral heat insulating part having a low thermal conductivity.

Furthermore, in this heat flow switching element, because the thermosensitive element part is joined to the upper high thermal conductive part and/or the lower high thermal conductive part, it is possible to detect a temperature change with more accuracy and with higher responsiveness by the thermosensitive element part joined to the high thermal conductive part present on the path of heat flow and having a high thermal conductivity.

A heat flow switching element according to a sixth invention is based on any of the first to fifth inventions, and includes a heat flow sensor part joined to the heat flow control element part and capable of detecting a direction of heat flow.

That is, because this heat flow switching element includes the heat flow sensor part joined to the heat flow control element part and capable of detecting the direction of heat flow, it is possible to control the thermal conductivity while confirming the direction of heat flow with the heat flow sensor part. Therefore, even when the heat flux input to and output from an object in thermal contact with the heat flow switching element changes with time, heat flow switching with a very high thermal responsiveness can be performed according to the current state of heat conduction.

A heat flow switching element according to a seventh invention is based on the sixth invention, wherein the heat flow sensor part includes: a plurality of anomalous Nernst material films extending in a same direction and arranged parallel to each other in a planar direction of the heat flow control element part, the plurality of anomalous Nernst material films exhibiting an anomalous Nernst effect; and a connection wiring electrically connecting the plurality of anomalous Nernst material films in series, and the anomalous Nernst material films are laminated on the heat flow control element part.

That is, in this heat flow switching element, because the anomalous Nernst material films are laminated on the heat flow control element part, the anomalous Nernst material films are in surface contact with the heat flow control element part, which reduces the thermal resistance, enables accurate detection of the direction of heat flow, and contributes to reducing the thickness.

In particular, because the plurality of anomalous Nernst material films in which a voltage is generated in the direction orthogonal to the direction of heat flow are arranged in the planar direction and electrically connected in series, it is possible to amplify the voltage without increasing the thickness by arranging the anomalous Nernst material films with a large number of wirings.

A heat flow switching element according to an eighth invention is based on the seventh invention, wherein the thermosensitive element part includes: a thin-film thermistor portion made of a thermistor material; and a pair of counter electrodes formed facing each other on an upper side and/or a lower side of the thin-film thermistor portion, and the thin-film thermistor portion and the anomalous Nernst material films are laminated on each other.

That is, in this heat flow switching element, because the thin-film thermistor portion and the anomalous Nernst material films are laminated on each other, the thin-film thermistor portion and the anomalous Nernst material films are in surface contact with each other, which reduces the thermal resistance, enables accurate temperature detection and accurate detection of the heat flow direction, and contributes to reducing the thickness. In addition, because the thin-film thermistor portion has a higher electric resistance and a higher insulating property than the anomalous Nernst material films, voltage detection for heat flow detection of the laminated anomalous Nernst material films is unlikely to be affected by the conductivity of the thin-film thermistor portion.

Advantageous Effects of Invention

The present invention achieves the following effects.

That is, the heat flow switching element according to the present invention has a composite structure including the thermosensitive element part joined to the heat flow control element part, so that while the temperature is directly monitored by the thermosensitive element part, the heat flow can be adjusted with high responsiveness by the heat flow control element part of the voltage application type capable of high-speed thermal response.

In addition, because of the N-type semiconductor layer, the insulator layer laminated on the N-type semiconductor layer, and the P-type semiconductor layer laminated on the insulator layer, the amount of electric charge generated by external voltage application is so large that a large change in thermal conductivity and a high thermal responsiveness can be obtained.

Brief Description of Drawings

Fig. 1 is a perspective view illustrating a first embodiment of a heat flow switching element according to the present invention.
Fig. 2 is a conceptual cross-sectional view illustrating the heat flow switching element in the first embodiment.
Fig. 3 is a plan view illustrating the heat flow switching element without an upper protective film in the first embodiment.
Fig. 4 is a conceptual diagram for explaining a principle in the first embodiment.
Fig. 5 is a perspective view illustrating a second embodiment of a heat flow switching element according to the present invention.
Fig. 6 is a conceptual cross-sectional view illustrating a third embodiment of a heat flow switching element according to the present invention.
Fig. 7 is a plan view illustrating the heat flow switching element without an upper protective film in the third embodiment.
Fig. 8 is a conceptual cross-sectional view illustrating a fourth embodiment of a heat flow switching element according to the present invention.
Fig. 9 is a plan view illustrating the heat flow switching element in the fourth embodiment.

Description of Embodiments

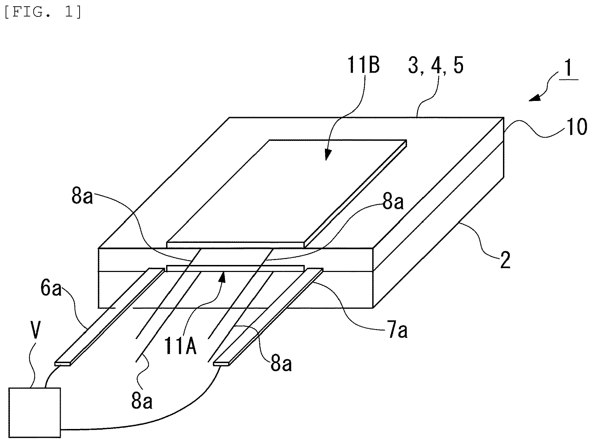

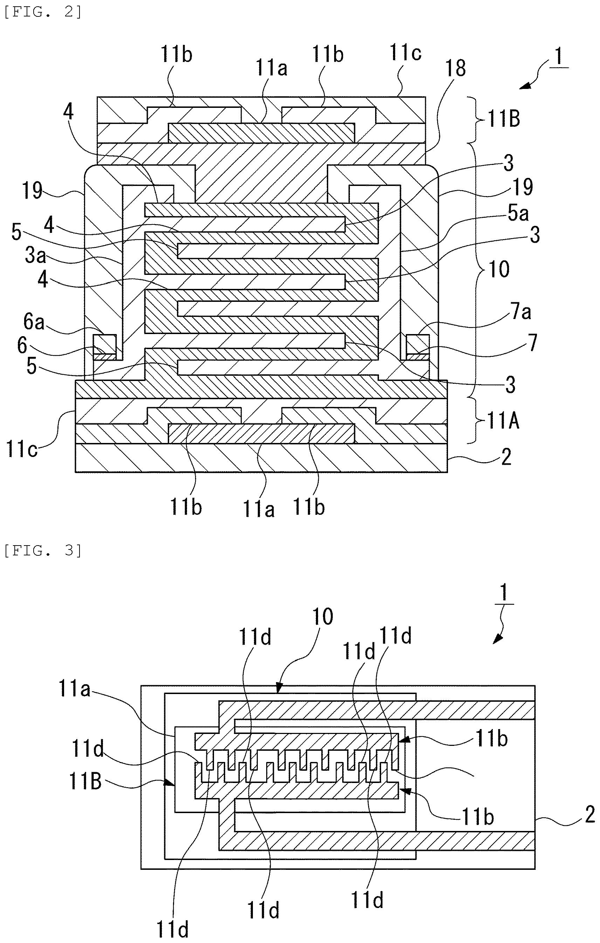

Hereinafter, a first embodiment of a heat flow switching element according to the present invention will be described with reference to Figs. 1 to 4. Note that in the drawings for use in the following description, the scale is appropriately changed as necessary in order to make each part recognizable or easily recognizable.
As illustrated in Figs. 1 and 2, the heat flow switching element 1 according to the present embodiment includes a heat flow control element part 10 and thermosensitive element parts 11A and 11B joined to the heat flow control element part 10. The heat flow control element part 10 includes an N-type semiconductor layer 3, an insulator layer 4 laminated on the N-type semiconductor layer 3, and a P-type semiconductor layer 5 laminated on the insulator layer 4.
As illustrated in Figs. 2 and 3, each of the thermosensitive element parts 11A and 11B includes a thin-film thermistor portion 11a made of a thermistor material, and a pair of counter electrodes 11b formed facing each other on an upper side and/or a lower side of the thin-film thermistor portion 11a. Note that an insulating protective film 11c is laminated on the thin-film thermistor portion 11a and the counter electrodes 11b.
In the present embodiment, as illustrated in Fig. 3, the pair of counter electrodes 11b is placed facing each other on the upper side of the thin-film thermistor portion 11a. Note that the pair of counter electrodes 11b is connected to a pair of lead wires 8a.
The thin-film thermistor portion 11a is laminated on an upper side and/or a lower side of the heat flow control element part 10.
In the present embodiment, the thermosensitive element parts 11A and 11B are provided on both the high temperature side and the low temperature side of the heat flow control element part 10.
That is, in the present embodiment, the heat flow direction is set to the lamination direction, and the thermosensitive element parts 11A and 11B are provided on both the upper portion and the lower portion of the heat flow control element part 10.
The heat flow switching element 1 according to the present embodiment also includes an upper high thermal conductive part 18 provided at an uppermost portion of the heat flow control element part 10, a lower high thermal conductive part 2 (base material) provided at a lowermost portion of the heat flow control element part 10, and an outer-peripheral heat insulating part 19 provided covering an outer peripheral edge of the N-type semiconductor layer 3, the insulator layer 4, and the P-type semiconductor layer 5.
The upper high thermal conductive part 18 and the lower high thermal conductive part 2 are made of a material having a higher thermal conductivity than the outer-peripheral heat insulating part 19.
The thermosensitive element parts 11A and 11B are joined to the upper high thermal conductive part 18 and/or the lower high thermal conductive part 2.
In the present embodiment, the thermosensitive element part 11B is joined onto the upper high thermal conductive part 18. In addition, the thermosensitive element part 11A is formed on the lower high thermal conductive part 2, and the heat flow control element part 10 is formed on the thermosensitive element part 11A with the protective film 11c interposed therebetween, whereby the thermosensitive element part 11A is joined to the heat flow control element part 10 via the protective film 11c.
Further, as illustrated in Fig. 2, the heat flow switching element 1 according to the present embodiment includes an N-side electrode 6 connected to the N-type semiconductor layer 3 and a P-side electrode 7 connected to the P-type semiconductor layer 5.

Various depositing methods can be adopted to form films, such as sputtering and molecular-beam epitaxy (MBE).

Note that when it is possible to apply a voltage directly to the N-type semiconductor layer 3 and the P-type semiconductor layer 5, the N-side electrode 6 and the P-side electrode 7 are unnecessary.

The N-side electrode 6 and the P-side electrode 7 are connected to lead wires 6a and 7a, respectively.

The N-side electrode 6 and the P-side electrode 7 are connected to an external power supply V so that a voltage is applied thereto.

The lower high thermal conductive part 2 is an insulating base material. On this base material (lower high thermal conductive part 2), the lower thermosensitive element part 11A, the heat flow control element part 10, and the upper thermosensitive element part 11B are laminated in this order.

For example, the upper high thermal conductive part 18 is made of a high thermal conductive material such as a silicon-based resin (silicone), and a high thermal conductive substrate made of alumina or the like is adopted as the lower high thermal conductive part 2, which is the base material.

The outer-peripheral heat insulating part 19 is made of a low thermal conductive material such as an epoxy resin.

The outer-peripheral heat insulating part 19 covers the periphery of the insulator layer 4 with its uppermost portion exposed, and the upper high thermal conductive part 18 is formed thereon in contact with the exposed uppermost portion of the insulator layer 4.

Note that the outer-peripheral heat insulating part 19 also covers the N-side electrode 6 and the P-side electrode 7 located on the outer periphery of the corresponding layers and connected to lead wires 6a and 7a.

In the heat flow control element part 10, a plurality of N-type semiconductor layers 3 and a plurality of P-type semiconductor layers 5 are alternately laminated with the insulator layers 4 interposed therebetween.

Specifically, the insulator layer 4 is first deposited on the lower thermosensitive element part 11A, and the N-type semiconductor layer 3 and the P-type semiconductor layer 5 are repeatedly laminated thereon in this order with the insulator layer 4 interposed therebetween, whereby a laminate of three N-type semiconductor layers 3, three P-type semiconductor layers 5, and seven insulator layers 4 is formed.

Each N-type semiconductor layer 3 is connected to an N-side coupling portion 3a provided at the base end thereof, and the N-side electrode 6 is formed in a part of the N-side coupling portion 3a. Each P-type semiconductor layer 5 is connected to a P-side coupling portion 5a provided at the base end thereof, and the P-side electrode 7 is formed in a part of the P-side coupling portion 5a.

Each of the above layers is patterned using a metal mask. Note that the plurality of N-type semiconductor layers 3, the plurality of P-type semiconductor layers 5, and the plurality of insulator layers 4 are laminated through depositing in which the position of the metal mask is shifted.

The N-type semiconductor layer 3 and the P-type semiconductor layer 5 are made of thin films having a thickness of less than 1 $\mu$m. In particular, because electric charges e generated at an interface with the insulator layer 4 and in the vicinity thereof are accumulated mainly in the thickness range of 5 to 10 nm, the N-type semiconductor layer 3 and the P-type semiconductor layer 5 are more preferably formed with a film thickness of 100 nm or less. Note that the N-type semiconductor layer 3 and the P-type semiconductor layer 5 preferably have a film thickness of 5 nm or more.

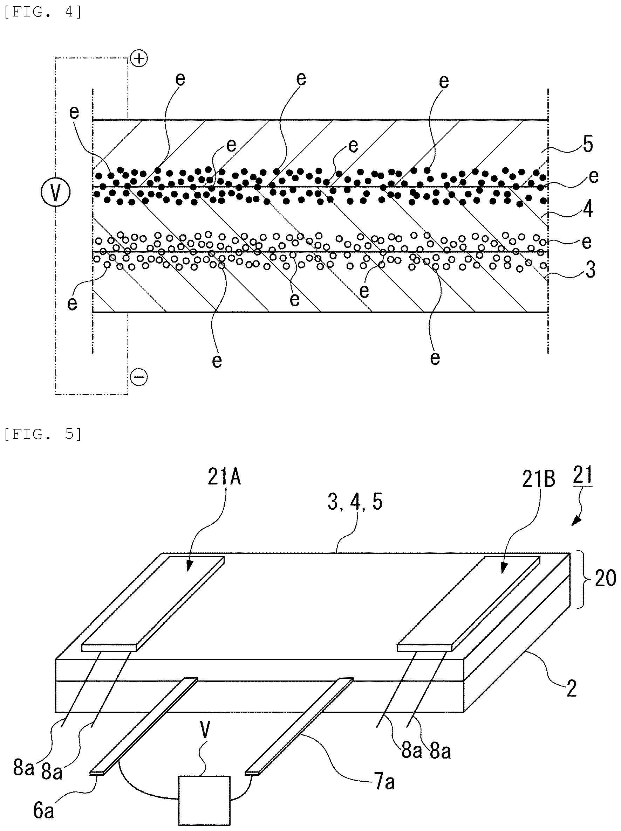

The insulator layer 4 preferably has a film thickness of 40 nm or more, and is set to a thickness that does not cause dielectric breakdown. Note that the insulator layer 4 preferably has a film thickness of less than 1 $\mu$m because too large a thickness makes it difficult to carry electric charges e. In Fig. 4, the type of electric charge e generated at the interface between the N-type semiconductor layer 3 and the insulator layer 4 and in the vicinity thereof is an electron, which is indicated by a white circle. In addition, the type of electric charge e generated at the interface between the P-type semiconductor layer 5 and the insulator layer 4 and in the vicinity thereof is an electron hole, which is indicated by a black circle. (An electron hole is a hole formed due to the lack of an electron in the valence band of a semiconductor, and appears to have a relatively positive electric charge.)

The N-type semiconductor layer 3 and the P-type semiconductor layer 5 are preferably degenerate semiconductor materials having low lattice thermal conduction, and for example, a thermoelectric material such as SiGe, a nitride semiconductor such as CrN, an oxide semiconductor such as $VO_2$, or the like can be adopted. Note that the N-type and P-type conductivities are set by adding N-type and P-type dopants to the semiconductor materials, for example.

The insulator layer 4 is preferably an insulating material having a low thermal conductivity, and an insulator such as $SiO_2$, a dielectric such as $HfO_2$ or $BiFeO_3$, an organic material such as polyimide (PI), or the like can be adopted. In particular, a dielectric material having a high dielectric constant is preferable.

The N-side electrode 6 and the P-side electrode 7 are made of a metal such as Mo or Al, for example.

As illustrated in Fig. 4, in the heat flow switching element 1 according to the present embodiment, electric charges e capable of heat conduction are generated at the interface between the N-type semiconductor layer 3 and the insulator layer 4 and in the vicinity thereof by application of an electric field (voltage), whereby the generated electric charges e carry heat and the thermal conductivity changes.

Note that the thermal conductivity is obtained using the following formula.

$$\text{Thermal conductivity} = \text{Lattice thermal conductivity}$$
$$+ \text{Electron thermal conductivity}$$

Among these two types of thermal conductivities, the electron thermal conductivity changes according to the amount of electric charge generated by application of an electric field (voltage). Therefore, in the present embodiment, a material having a smaller lattice thermal conductivity is suitable for obtaining a larger change in thermal conductivity. Therefore, for any of the N-type semiconductor layer 3, the insulator layer 4, and the P-type semiconductor layer 5, a material having a smaller lattice thermal conductivity, that is, a material having a smaller thermal conductivity, is selected.

The thermal conductivity of the material constituting each layer of the present embodiment is preferably as low as 5 W/mK or less, and more preferably 1 W/mK or less, which can be achieved by adopting the above-described materials.

In addition, the electron thermal conductivity increases according to the amount of electric charge e generated according to the applied external electric field (voltage).

Note that because electric charges e are generated at the interfaces between the N-type semiconductor layer 3 and the insulator layer 4 and between the P-type semiconductor layer 5 and the insulator layer 4, the amount of generated electric charge e can be increased by increasing the total area of the interfaces.

An example of a method for measuring the thermal conductivity is a pulsed light heating thermoreflectance method, which involves instantaneously heating a thin film sample formed on a substrate with a pulse laser, and measuring the rate of decrease in surface temperature or the rate of increase in surface temperature due to thermal diffusion into the thin film, thereby obtaining the thermal diffusivity or the thermal permeability of the thin film in the film pressure direction. Note that a type of pulsed light heating thermoreflectance method in which thermal diffusion is directly measured is called rear heating/front detection (RF), which requires the use of a transparent substrate through which a pulse laser can pass; therefore, when the substrate is not a transparent substrate, the thermal conductivity is measured using font heating/front detection (FF), which is a type of pulsed light heating thermoreflectance method in which the thermal permeability is measured and converted into a thermal conductivity. Note that this measurement requires a metal film, for which Mo, Al, or the like is adopted.

In the thermosensitive element parts 11A and 11B, as illustrated in Fig. 3, the pair of counter electrodes 11b each have a comb shape having a plurality of comb portions 11d protruding in the opposite direction, and the comb portions 11d of one counter electrode 11b and the comb portions 11d of the other counter electrode 11b are alternately arranged side by side.

As the counter electrodes 11b, for example, various metal films such as a single layer of a Cr film and a laminated metal film of a Cr film and an Au film can be adopted.

As the thin-film thermistor portion 11a, an NTC thermistor (element which exhibits a negative temperature characteristic and whose electric resistance value exponentially decreases with increase in temperature) is generally adopted. Alternatively, in order to quickly detect abnormal temperature detection, a PTC thermistor (element which exhibits a positive temperature characteristic and whose electric resistance value increases with increase in temperature, or an element which exhibits a positive temperature characteristic and whose electric resistance value rapidly increases with increase in temperature once the temperature exceeds a certain temperature), or a CTR thermistor (element which is similar to NTC in that it has a negative temperature coefficient, but whose electric resistance value rapidly decreases once the temperature exceeds a certain temperature range) may be adopted.

Generally-known materials for the NTC thermistor are oxide materials, examples of which include oxides such as $(Mn, Co, Ni)_3O_4$ having a spinel-type crystal structure and $(La, Ca)(Cr, Mn)O_3$ having a perovskite-type crystal structure. However, the thin-film thermistor portion 11a in the present embodiment is preferably made of a material consisting of a hexagonal wurtzite single-phase metal nitride indicated by the general formula $M_xA_yN_z$ (where M represents at least one of Ti, V, Cr, Mn, Fe, Co, Ni, and Cu, and A represents Al or (Al and Si); $0.70 \leq y/(x + y) \leq 0.98$, $0.4 \leq z \leq 0.5$, $x + y + z = 1$). In the present embodiment, as the thin-film thermistor portion 11a, a hexagonal wurtzite single-phase metal nitride indicated by the general formula $Ti_xAl_yN_z$ (where $0.70 \leq y/(x + y) \leq 0.98$, $0.4 \leq z \leq 0.5$, $x + y + z = 1$) is adopted.

For example, in the case of Ti-Al-N, the thin-film thermistor portion 11a is deposited by performing reactive sputtering in a nitrogen-containing atmosphere using a Ti-Al alloy sputtering target.

The wurtzite crystal structure is a hexagonal space group $P6_3mc$ (No. 186), and M and A belong to the same atomic site (M represents at least one of Ti, V, Cr, Mn, Fe, Co, Ni, and Cu, and A represents Al or (Al and Si)), and are in what is called a solid solution state. The wurtzite form has a vertex-connected structure of $(M, A)N_4$ tetrahedra, the nearest site to the (M, A) site is N (nitrogen), and (M, A) has four-nitrogen coordination.

In addition to Ti, V (vanadium), Cr (chromium), Mn (manganese), Fe (iron), Co (cobalt), Ni (nickel), and Cu (copper) can similarly exist at the same atomic site as Ti in the crystal structure, and can be an element of M. Effective ionic radius is a physical property value that is often used to identify the distance between atoms. Using Shannon's well-known ionic radii, it can be estimated that wurtzite $M_xA_yN_z$ (where M represents at least one of Ti, V, Cr, Mn, Fe, Co, Ni, and Cu, and A represents Al or (Al and Si)) is logically obtained.

The effective ionic radii of ion species Al, Ti, V, Cr, Mn, Fe, Co, Ni, Cu, and Si are shown in Table 1 below (reference article: R. D. Shannon, Acta Crystallogr., Sect. A, 32, 751 (1976)).

Note that the thermistor characteristic of Ti-Al-N is obtained by carrier doping that replaces the Al site of Al-N, i.e. a nitride insulator having a wurtzite crystal structure, partially with Ti to increase electrical conduction. Regarding V, Cr, Mn, Fe, Co, Ni, and Cu, which are 3d transition metals similarly to Ti, thermistor characteristics can be obtained in wurtzite $M_xA_yN_z$ (where M represents at least one of Ti, V, Cr, Mn, Fe, Co, Ni, and Cu, and A represents Al or (Al and Si)).

[Table 1]

| Effective ionic radii | | | | |
|---|---|---|---|---|
| Reference article **R.D.Shannon, Acta Crystallogr., Sect.A, 32, 751(1976)** | | | | |
| 4 coordination | | 6 coordination (for reference) | | Unit : nm |
| Ion species | Ionic radius | Ion species | Ionic radius | |
| $Al^{3+}$ | 0.039 | $Al^{3+}$ | 0.0535 | |
| $Ti^{4+}$ | 0.042 | $Ti^{3+}$ | 0.067 | |
| $V^{5+}$ | 0.0355 | $V^{3+}$ | 0.064 | |
| $Cr^{4+}$ | 0.041 | $Cr^{3+}$ | 0.0615 | |
| $Cr^{5+}$ | 0.0345 | | | |
| $Mn^{2+}$ | 0.066 | $Mn^{3+}$ (HS) | 0.0645 | |
| $Mn^{4+}$ | 0.039 | | | |
| $Mn^{5+}$ | 0.033 | $Mn^{3+}$ (LS) | 0.058 | |
| $Fe^{2+}$ | 0.063 | $Fe^{3+}$ (HS) | 0.0645 | |
| $Fe^{3+}$ | 0.049 | $Fe^{3+}$ (LS) | 0.055 | |
| $Co^{2+}$ | 0.058 | $Co^{3+}$ (HS) | 0.061 | |
| $Co^{4+}$ | 0.04 | $Co^{3+}$ (LS) | 0.0545 | |
| $Ni^{2+}$ | 0.055 | $Ni^{3+}$ (HS) | 0.060 | |
| | | $Ni^{3+}$ (LS) | 0.056 | |
| $Cu^{2+}$ | 0.057 | $Cu^{3+}$ (LS) | 0.054 | |
| $Si^{4+}$ | 0.026 | $Si^{4+}$ | 0.040 | |

As described above, the thin-film thermistor portion 11a is formed by applying an NTC thermistor, a PTC thermistor, a CTR thermistor, or various thermistor materials, and in general, formed by adopting an NTC thermistor which exhibits a negative temperature characteristic and whose electric resistance value continuously decreases with increase in temperature. Note that if a PTC thermistor whose electric resistance value rapidly increases with increase in temperature once the temperature exceeds a certain temperature or a CTR thermistor whose electric resistance value rapidly decreases with increase in temperature once the temperature exceeds a certain temperature is used as the thin-film thermistor portion 11a, abnormal temperature can be detected more quickly, and the heat flow of the heat flow control element part can be adjusted with high responsiveness.

For the PTC thermistor, a material which exhibits a positive temperature characteristic and whose electric resistance value rapidly increases with increase in temperature once the temperature exceeds a certain temperature is adopted. Examples of such materials include $BaTiO_3$, $SrTiO_3$, a compound based on these materials in which a small amount of metal element such as Pb is partially substituted, and a conductive polymer (polymer containing conductive particles dispersed therein; the polymer is melted to cut off the contact of the conductive powder and increase the electric resistance).

For the CTR thermistor, a metal insulator transition material whose electric resistance value rapidly decreases with increase in temperature once the temperature exceeds a certain temperature is adopted. Examples of such materials include $VO_2$ and a compound based on this material in which a small amount of metal element is partially substituted.

Various depositing methods such as sputtering, solgel processing, and printing are applied to prepare a thin film made of these PTC thermistor or CTR thermistor materials.

As described above, the heat flow switching element 1 according to the present embodiment includes: the heat flow control element part 10 including the N-type semiconductor layer 3, the insulator layer 4 laminated on the N-type semiconductor layer 3, and the P-type semiconductor layer 5 laminated on the insulator layer 4; and the thermosensitive element parts 11A and 11B joined to the heat flow control element part 10. Therefore, a voltage applied to the P-type semiconductor layer 5 and the N-type semiconductor layer 3 induces electric charges e mainly at the interfaces between the P-type semiconductor layer 5 and the insulator layer 4 and between the N-type semiconductor layer 3 and the insulator layer 4, and the thermal conductivity changes as the electric charges e carry heat.

In particular, because electric charges e induced by the external voltage are generated both at the interface between the N-type semiconductor layer 3 and the insulator layer 4 and in the vicinity thereof and at the interface between the P-type semiconductor layer 5 and the insulator layer 4 and in the vicinity thereof, the amount of generated electric charge is so large that a large change in thermal conductivity and a high thermal responsiveness can be obtained. In addition, because of the mechanism that physically changes the thermal conductivity without using a chemical reaction mechanism, it is possible to immediately transition to a state in which thermal conduction has changed, and to obtain good thermal responsiveness.

In addition, because the amount of electric charge induced at the interfaces changes depending on the magnitude of the external voltage, it is possible to adjust the thermal conductivity by adjusting the external voltage, and thus to actively control the heat flow through the present element.

Note that the lower high thermal conductive part 2, which is the base material, is an insulator in which no current is generated due to voltage application; therefore, no Joule heat is generated. Thus, it is possible to actively control the heat flow without self-heating.

Furthermore, the heat flow switching element 1 has a composite structure including the thermosensitive element parts 11A and 11B joined to the heat flow control element part 10. Therefore, the temperature change associated with a change in thermal conductivity by the heat flow control element part 10 can be directly detected by the thermosensitive element parts 11A and 11B. That is, while the temperature is directly monitored by the thermosensitive element parts 11A and 11B, the heat flow can be adjusted with high responsiveness by the heat flow control element part 10 of the voltage application type capable of high-speed thermal response.

In particular, because the thin-film thermistor portion 11a is laminated on the upper side and/or the lower side of the heat flow control element part 10, the thin-film thermistor portion 11a is in surface contact with the heat flow control element part 10, which reduces the thermal resistance, enables accurate temperature detection, and contributes to reducing the thickness.

In addition, because the thermosensitive element parts 11A and 11B are provided on both the high temperature side and the low temperature side of the heat flow control element part 10, it is possible to detect the temperatures on both the high temperature side and the low temperature side of the heat flow control element part 10, and to more accurately detect the state of heat conduction that changes from moment to moment according to the heat flow direction. In addition, because the heat flow can be adjusted by the external voltage in the heat flow control element part according to the temperatures detected on both the high temperature side and the low temperature side, even when the temperature of an object in thermal contact with the heat flow switching element changes with time, heat flow switching with a very high thermal responsiveness can be performed according to the current state of heat conduction.

Furthermore, because the plurality of N-type semiconductor layers 3 and the plurality of P-type semiconductor layers 5 are alternately laminated with the insulator layers 4 interposed therebetween, a plurality of interfaces are formed between the N-type semiconductor layers 3 and the insulator layers 4 and between the P-type semiconductor layers 5 and the insulator layers 4, which induces a large number of electric charges e that can cause a significant change in thermal conductivity.

Next, second to fourth embodiments of heat flow switching elements according to the present invention will be described below with reference to Figs. 5 to 8. In the following description of each embodiment, components identical to those described in the above embodiment are denoted by the same reference signs, and the description thereof will be omitted.

The difference between the second embodiment and the first embodiment is that whereas the thermosensitive element parts 11A and 11B in the first embodiment are provided on the upper side and the lower side of the heat flow control element part 10, a heat flow switching element 21 according to the second embodiment is provided with a pair of thermosensitive element parts 21A and 21B apart from each other on the upper surface of a heat flow control element part 20, as illustrated in Fig. 5.

That is, in the second embodiment, the heat flow direction is the in-plane direction (planar direction) of the heat flow control element part 20, the thermosensitive element part 21A is installed on the end portion on the high temperature side, and the thermosensitive element part 21B is installed on the end portion on the low temperature side.

Note that the heat flow control element part 20 according to the second embodiment is provided in a band shape longer along the heat flow direction than in the first embodiment.

Thus, the heat flow switching element 21 according to the present embodiment also includes the thermosensitive element parts 21A and 21B provided on both the high temperature side and the low temperature side of the heat flow control element part 20, it is possible to detect the temperatures on both the high temperature side and the low temperature side of the heat flow control element part 20, and to more accurately detect the state of heat conduction according to the heat flow direction.

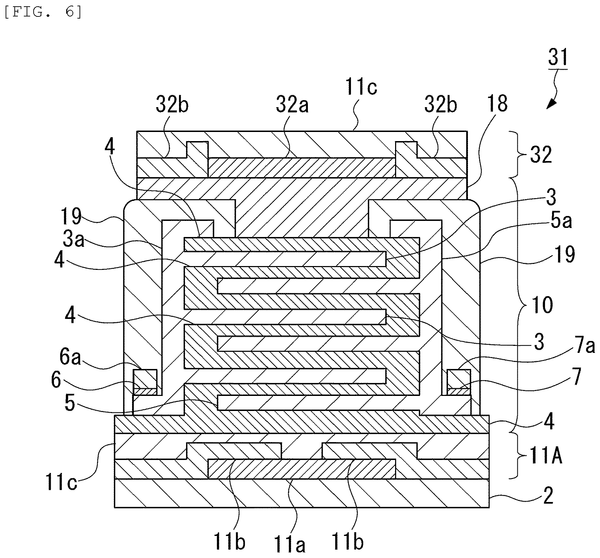

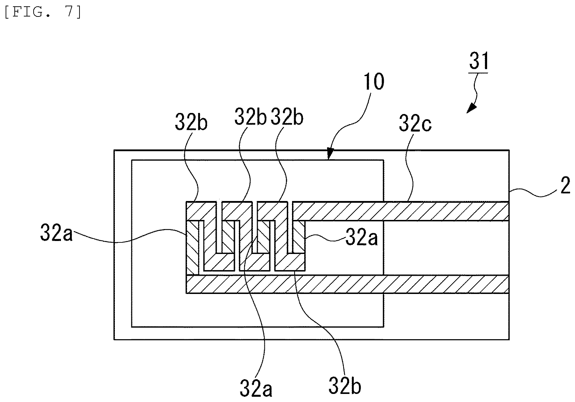

Next, the difference between the third embodiment and the first embodiment is that whereas the thermosensitive element parts 11A and 11B in the first embodiment are provided on the upper side and the lower side of the heat flow control element part 10, a heat flow switching element 31 according to the third embodiment is provided with the thermosensitive element part 11A only on the lower side of the heat flow control element part 10, and provided with a heat flow sensor part 32 capable of detecting the direction of heat flow on the upper side of the heat flow control element part 10, as illustrated in Figs. 6 and 7.

That is, the heat flow switching element 31 according to the third embodiment includes the heat flow sensor part 32 joined to the heat flow control element part 10 and capable of detecting the direction of heat flow or/and the heat flux.

The heat flow sensor part 32 includes a plurality of anomalous Nernst material films 32a and a connection wiring 32b electrically connecting the plurality of anomalous Nernst material films 32a in series. The plurality of anomalous Nernst material films 32a extend in the same direction, are arranged parallel to each other in the planar direction of the heat flow control element part 10, and exhibit an anomalous Nernst effect.

Each of the ends of the anomalous Nernst material films 32a connected in series is connected to an electrode wiring 32c.

The connection wiring 32b and the electrode wiring 32c are preferably an Au film having a small electromotive force, but a laminated metal film of a Cr film and an Au film or the like can also be adopted.

The anomalous Nernst material films 32a are laminated on the heat flow control element part 10.

That is, the anomalous Nernst material films 32a, the connection wiring 32b, and the electrode wiring 32c are deposited on the upper high thermal conductive part 18 formed on the heat flow control element part 10.

The plurality of anomalous Nernst material films 32a are formed in a band shape or a line shape arrayed parallel to each other with respect to the direction of the voltage that is generated with respect to the heat flow in the thickness direction.

Note that the obtained voltage can be increased by increasing the number of anomalous Nernst material films 32a connected in series and/or the length thereof.

As the anomalous Nernst material films 32a, a ferromagnetic material having large spontaneous magnetization such as an Fe-Al, Fe-Pt, or Co-Pt material or a Heusler alloy material such as $Co_2MnGa$, $Co_2MnAl$, or $Co_2MnSi$, an antiferromagnetic material such as $Mn_2Sn$, or the like can be adopted.

In the process of forming the anomalous Nernst material films, the anomalous Nernst material films 32a are deposited by performing sputtering using an Fe-Al alloy sputtering target, for example.

As described above, in the heat flow switching element 31 according to the third embodiment, because the anomalous Nernst material films 32a are laminated on the heat flow control element part 10, the anomalous Nernst material films 32a are in surface contact with the heat flow control element part 10, which reduces the thermal resistance, enables accurate detection of the direction of heat flow, and contributes to reducing the thickness.

In particular, because the plurality of anomalous Nernst material films 32a in which a voltage is generated in the direction orthogonal to the direction of heat flow are arranged in the planar direction and electrically connected in series, it is possible to amplify the voltage without increasing the thickness by arranging the anomalous Nernst material films 32a with a large number of wirings.

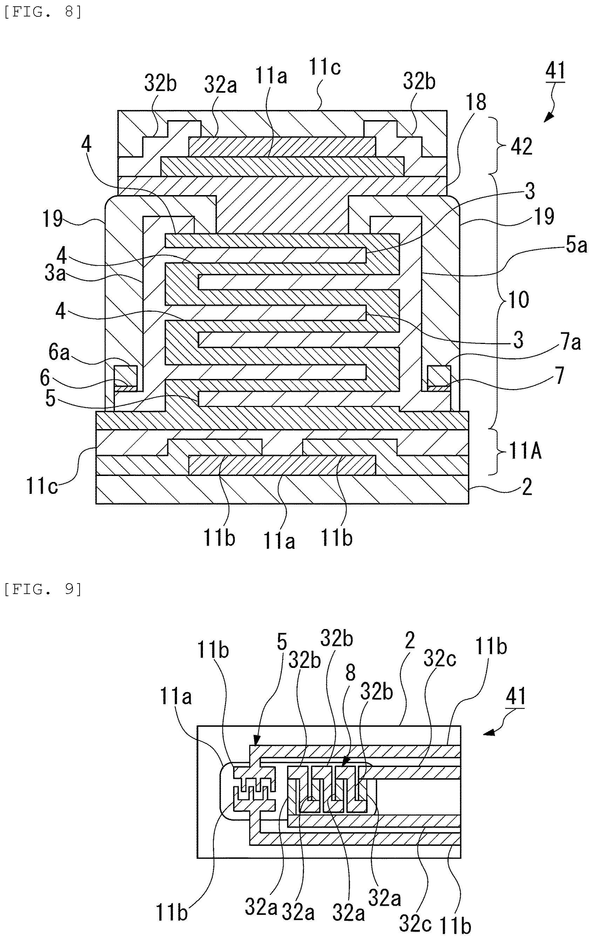

Next, the difference between the fourth embodiment and the third embodiment is that whereas only the heat flow sensor part 32 is provided on the heat flow control element part 10 in the third embodiment, a heat flow switching element 41 according to the fourth embodiment is provided with a composite element part 42 having a temperature sensing function and a heat flow measurement function on the heat flow control element part 10, as illustrated in Figs. 8 and 9.

That is, in the fourth embodiment, the thin-film thermistor portion 11a and the anomalous Nernst material films 32a are laminated in this order on the upper high thermal conductive part 18 formed on the heat flow control element part 10 to constitute the composite element part 42.

As described above, in the heat flow switching element 41 according to the fourth embodiment, because the thin-film thermistor portion 11a and the anomalous Nernst material films 32a are laminated on each other, the thin-film thermistor portion 11a and the anomalous Nernst material films 32a are in surface contact with each other, which reduces the thermal resistance, enables accurate temperature detection and accurate detection of the heat flow direction, and contributes to reducing the thickness.

Note that the thin-film thermistor portion 11a has a higher electric resistance than the anomalous Nernst material films 32a. In particular, when the thin-film thermistor portion is made of a metal nitride thin film represented by the general formula $Ti_xAl_yN_z$ (where $0.70 \leq y/(x + y) \leq 0.98$, $0.4 \leq z \leq 0.5$, $x + y + z = 1$), which not only achieves a high B constant and a high thermal conductivity but also has a relatively high insulating property, voltage detection for heat flow detection of the laminated anomalous Nernst material films 32a is unlikely to be affected by the conductivity of the thin-film thermistor portion 11a.

Note that the technical scope of the present invention is not limited to the above embodiments, and various modifications can be made without departing from the gist of the present invention.

For example, it is preferable to adopt a thermosensitive element part including a thin-film thermistor portion in order to lower the thermal resistance, but a thermosensitive element part including a thermocouple, a temperature measuring resistor, a chip thermistor, or the like may be adopted. As the thin-film thermistor portion, various metal oxide materials and various metal nitride materials can be adopted.

Reference Signs List

| | |
|---|---|
| 1, 21, 31, 41 | heat flow switching element |
| 2 | lower high thermal conductive part (base material) |
| 3 | N-type semiconductor layer |
| 4 | insulator layer |
| 5 | P-type semiconductor layer |
| 6 | N-side electrode |
| 7 | P-side electrode |
| 10 | heat flow control element part |
| 11A, 11B | thermosensitive element part |
| 11a | thin-film thermistor portion |
| 11b | counter electrode |
| 18 | upper high thermal conductive part |
| 19 | outer-peripheral heat insulating part |
| 32 | heat flow sensor part |
| 32a | anomalous Nernst material film |
| 32b | connection wiring |

Claims

1. A heat flow switching element comprising:

   a heat flow control element part including
   an N-type semiconductor layer,
   an insulator layer laminated on the N-type semiconductor layer, and
   a P-type semiconductor layer laminated on the insulator layer; and
   a thermosensitive element part joined to the heat flow control element part.

2. The heat flow switching element according to claim 1, wherein
   the thermosensitive element part includes:

   a thin-film thermistor portion made of a thermistor material; and
   a pair of counter electrodes formed facing each other on an upper side and/or a lower side of the thin-film thermistor portion, and
   the thin-film thermistor portion is laminated on an upper side and/or a lower side of the heat flow control element part.

3. The heat flow switching element according to claim 1, wherein
   the thermosensitive element part is provided on each of a high temperature side and a low temperature side of the heat flow control element part.

4. The heat flow switching element according to claim 1, wherein
in the heat flow control element part, a plurality of the N-type semiconductor layers and a plurality of the P-type semiconductor layers are alternately laminated with the insulator layer interposed.

5. The heat flow switching element according to claim 1, comprising:

an upper high thermal conductive part provided at an uppermost portion of the heat flow control element part;
a lower high thermal conductive part provided at a lowermost portion of the heat flow control element part; and
an outer-peripheral heat insulating part provided covering an outer peripheral edge of the N-type semiconductor layer, the insulator layer, and the P-type semiconductor layer, wherein
the upper high thermal conductive part and the lower high thermal conductive part are made of a material having a higher thermal conductivity than the outer-peripheral heat insulating part, and
the thermosensitive element part is joined to the upper high thermal conductive part and/or the lower high thermal conductive part.

6. The heat flow switching element according to claim 1, comprising
a heat flow sensor part joined to the heat flow control element part and capable of detecting a direction of heat flow.

7. The heat flow switching element according to claim 6, wherein
the heat flow sensor part includes:

a plurality of anomalous Nernst material films extending in a same direction and arranged parallel to each other in a planar direction of the heat flow control element part, the plurality of anomalous Nernst material films exhibiting an anomalous Nernst effect; and
a connection wiring electrically connecting the plurality of anomalous Nernst material films in series, and
the anomalous Nernst material films are laminated on the heat flow control element part.

8. The heat flow switching element according to claim 7, wherein
the thermosensitive element part includes:

a thin-film thermistor portion made of a thermistor material; and
a pair of counter electrodes formed facing each other on an upper side and/or a lower side of the thin-film thermistor portion, and
the thin-film thermistor portion and the anomalous Nernst material films are laminated on each other.

[FIG. 1]

[FIG. 2]

[FIG. 3]

[FIG. 4]

[FIG. 5]

[FIG. 6]

[FIG. 7]

[FIG. 8]

[FIG. 9]

## INTERNATIONAL SEARCH REPORT

| International application No. |
| --- |
| PCT/JP2021/005893 |

A. CLASSIFICATION OF SUBJECT MATTER
G01K 1/14(2021.01)i; G01K 7/22(2006.01)i; G01K 17/06(2006.01)i; H01L 37/00(2006.01)i
FI: G01K1/14 L; G01K7/22 A; G01K17/06; H01L37/00

According to International Patent Classification (IPC) or to both national classification and IPC

B. FIELDS SEARCHED

Minimum documentation searched (classification system followed by classification symbols)
G01K1/00-19/00; H01L37/00,49/00; C09K5/08-5/14

Documentation searched other than minimum documentation to the extent that such documents are included in the fields searched
|  |  |
| --- | --- |
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y<br>A | MATSUNAGA, Takuya et al., "Development of a new heat flow switching device", The 38th International Conference on Thermoelectrics and The 4th Asian Conference on Thermoelectrics, Abstract Book, 2019, fig. 1 | 1–3<br>4–8 |
| Y | JP 2016-37913 A (TOYOTA MOTOR CORP.) 22 March 2016 (2016-03-22) paragraph [0052], 9 | 1–3 |
| Y | JP 2019-138798 A (MITSUBISHI MATERIALS CORP.) 22 August 2019 (2019-08-22) fig. 2 | 2 |
| A | WO 2004/068604 A1 (MATSUSHITA ELECTRIC INDUSTRIAL CO., LTD.) 12 August 2004 (2004-08-12) | 1–8 |
| A | JP 2014-133852 A (FUJIKURA KASEI CO., LTD.) 24 July 2014 (2014-07-24) | 1–8 |

☐ Further documents are listed in the continuation of Box C.  ☒ See patent family annex.

| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| --- | --- |

| Date of the actual completion of the international search<br>15 April 2021 (15.04.2021) | Date of mailing of the international search report<br>11 May 2021 (11.05.2021) |
| --- | --- |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

| Patent Documents referred in the Report | Publication Date | Patent Family | Publication Date |
|---|---|---|---|
| JP 2016-37913 A | 22 Mar. 2016 | (Family: none) | |
| JP 2019-138798 A | 22 Aug. 2019 | (Family: none) | |
| WO 2004/068604 A1 | 12 Aug. 2004 | US 2004/0232893 A1 US 2007/0069192 A1 US 2008/0258690 A1 CN 1745485 A | |
| JP 2014-133852 A | 24 Jul. 2014 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2781892 B
- JP 5402346 B
- JP 2016216688 A

**Non-patent literature cited in the description**

- **TAKUYA MATSUNAGA.** Preparation of Heat Flow Switching Element Operated with Bias Voltage. *15th Meeting of the Thermoelectrics Society of Japan,* 13 September 2018